# EUROPÄISCHE PATENTSCHRIFT

(11) **EP 2 976 834 B1**
(45) Veröffentlichungstag und Bekanntmachung des Hinweises auf die Patenterteilung: **06.05.2020**
(21) Anmeldenummer: 14710888.0
(22) Anmeldetag: 18.03.2014
(51) Int. Cl.: H03M 1/12, H03M 1/20, G02F 7/00

(54) **ANALOG-DIGITAL-KONVERTER UND VERFAHREN ZUM ERZEUGEN EINES DIGITALEN DATENSTROMES**
ANALOGUE-DIGITAL CONVERTER AND METHOD FOR GENERATING A DIGITAL DATA STREAM
CONVERTISSEUR ANALOGIQUE-NUMÉRIQUE ET PROCÉDÉ POUR GÉNÉRER UN FLUX DE DONNÉES NUMÉRIQUES

(30) Priorität: 18.03.2013 DE 102013204731
(43) Veröffentlichungstag der Anmeldung: 27.01.2016
(73) Patentinhaber: FRAUNHOFER-GESELLSCHAFT zur Förderung der angewandten Forschung e.V., 80636 München (DE)
(72) Erfinder: SCHELL, Martin, 10437 Berlin (DE)
(74) Vertreter: Friese Goeden Patentanwälte PartGmbB
(86) Internationale Anmeldenummer: PCT/EP2014/055387
(87) Internationale Veröffentlichungsnummer: WO 2014/147058

(56) Entgegenhaltungen:
- WO-A1-2012/073243
- US-A1- 2012 212 360
- US-H- H 353
- GEORGE C. VALLEY: "Photonic analog-to-digital converters", OPTICS EXPRESS, Bd. 15, Nr. 5, Januar 2007 (2007-01), Seite 1955, XP55143374, ISSN: 1094-4087, DOI: 10.1364/OE.15.001955

## Beschreibung

Die Erfindung betrifft einen Analog-Digital-Konverter mit zumindest einem Eingang, welchem zumindest ein analoges Eingangssignal zuführbar ist und mit zumindest einem Ausgang, welcher dazu eingerichtet ist, einen digitalen Datenstrom auszugeben, welcher das analoge Eingangssignal repräsentiert. Weiterhin betrifft die Erfindung ein Verfahren zur Erzeugung eines digitalen Datenstromes, welcher ein analoges Eingangssignal repräsentiert. Vorrichtungen und Verfahren der Eingangs genannten Art werden beispielsweise dazu eingesetzt, die Ausgangssignale von Sensoren, Audio- oder Videodaten zu digitalisieren, um die Signale digital weiterverarbeiten zu können.
Aus P. T. Callahan, M. L. Dennis, T. R. Clark: Photonic analogue to digital conversion, John Hopkins APL Technical Digest, vol. 30, no. 4 (2012) 280 ist ein Analog-Digital-Konverter der Eingangs genannten Art bekannt. Dieser Analog-Digital-Konverter führt im Wesentlichen zwei Funktionen aus: Einerseits wird die Amplitude des analogen Eingangssignals in diskreten Schritten abgetastet. Andererseits wird der Zeitverlauf mit einer vorgebbaren Abtastrate diskretisiert. Nach dem Nyquist-Theorem muss die Abtastrate des analogen Signals zumindest das Doppelte der Maximalfrequenz des analogen Eingangssignals betragen, um eine eindeutige Rekonstruktion des analogen Eingangssignals aus den digitalen Daten zu ermöglichen. Zu den durch die Abtastrate vorgegebenen Zeiten wird die Amplitude in einer vorgebbaren Anzahl von Stufen diskretisiert. Beispielsweise kann ein Analog-Digital-Konverter mit einer Auflösung von 8 Bit 256 Stufen der Amplitude unterscheiden. Fehler bei der analog/digital-Wandlung entstehen insbesondere aufgrund einer zu geringen Auflösung der Amplitude oder durch Fehler bei der Diskretisierung der Zeitachse. Die Diskretisierung der Zeitachse muss umso genauer erfolgen, je höher die Bandbreite des Eingangssignals ist. Somit gelangen konventionelle, rein elektronisch arbeitende Analog-Digital-Konverter insbesondere bei hohen Frequenzen des analogen Signals und/oder hohen Genauigkeitsanforderungen an ihre Grenzen.

Der genannte Stand der Technik schlägt daher vor, das elektrische analoge Eingangssignal auf einen optischen Träger zu modulieren, dieses modulierte Signal mittels einer Photodiode wiederum in ein elektrisches Signal zu wandeln und einem an sich bekannten elektronischen Analog-Digital-Wandler zuzuführen. Als optisches Trägersignal wird dabei ein Kurzpulslaser verwendet, welcher Pulsbreiten von weniger als einer Pikosekunde erzeugt. Diese Laserpulse mit konstanter Amplitude werden einem elektrooptischen Modulator zugeführt, welcher durch das analoge Eingangssignal angesteuert wird. Am Ausgang des elektrooptischen Modulators steht ein Pulszug zur Verfügung, bei welchem der zeitliche Abstand der Einzelpulse die Diskretisierung der Zeitachse darstellt und die Amplitude des Eingangssignals als Amplitudenvariation der Einzelpulse auf dem optischen Trägersignal kodiert ist. Aufgrund der hohen Zeitkonstanz des Lasers kann die Diskretisierung der Zeitachse mit hoher Frequenz erfolgen. Mit einem optischen Schalter hoher Schaltfrequenz wird das optische Signal auf mehrere parallele Analog-Digital-Wandler verteilt, so dass gegenüber einer rein elektrischen Analog/Digital-Wandlung ein Mehrfaches der Bandbreite erreicht wird.

Dennoch weist dieser bekannte Analog-Digital-Konverter den Nachteil auf, dass die Auflösung des nachgeschalteten elektronischen Analog-Digital-Wandler die verfügbare Auflösung limitiert.

Ein weiterer Analog-Digital-Wandler ist aus der US-H-353, veröffentlicht am 6. Oktober 1987, bekannt.

Ausgehend vom Stand der Technik liegt der Erfindung somit die Aufgabe zugrunde, einen Analog-Digital-Konverter bereitzustellen, welcher eine höhere Auflösung und/oder eine größere Abtastfrequenz ermöglicht, und auf diese Weise analoge Eingangssignale mit einer hohen Frequenz zuverlässig mit hoher Auflösung digitalisieren kann.
Die Aufgabe wird erfindungsgemäß durch einen Analog-Digital-Konverter nach Anspruch 1 und ein Verfahren gemäß Anspruch 10 gelöst.
Erfindungsgemäß wird ein Analog-Digital-Konverter vorgeschlagen, welcher zumindest einen Eingang aufweist, welchem zumindest ein analoges Eingangssignal zuführbar ist. Das analoge Eingangssignal kann beispielsweise ein Audio- oder Videosignal sein, welches digital übertragen, bearbeitet und/oder gespeichert werden soll. In anderen Ausführungsformen der Erfindung kann das zumindest eine analoge Eingangssignal das Ausgangssignal eines Sensors bzw. Messwertgebers sein, welcher eine physikalische Größe bestimmt, beispielsweise in einem Fahr- oder Flugzeug, einer Radaranlage oder in einer industriellen Produktionsanlage. Selbstverständlich ist die Erfindung nicht auf die genannten Beispiele beschränkt. In anderen Ausführungsformen der Erfindung kann das zumindest eine analoge Eingangssignal auch aus einer anderen Quelle stammen.
Der Analog-Digital-Konverter ist dazu eingerichtet, einen digitalen Datenstrom zu erzeugen, welcher das analoge Eingangssignal repräsentiert. Der digitale Datenstrom kann als serieller oder paralleler Datenstrom am Ausgang des Analog-Digital-Konverters bereitgestellt werden. Innerhalb des Analog-Digital-Konverters kann das Signal mit einer vorgebbaren Samplingrate und einer vorgebbaren Auslösung digitalisiert werden. Dabei ist angestrebt, dass die Samplingfrequenz zumindest das Doppelte der maximalen Frequenz des analogen Eingangssignals beträgt und für die Genauigkeit der Samplingfrequenz bzw. den Jitter δt folgender Zusammenhang gilt: δt < 1/(2^{q}πf₀) ist, wobei q die Auflösung des Analog-Digital-Konverters in Bit beschreibt und f₀ die Maximalfrequenz des Eingangssignals bezeichnet.

Um analoge Eingangssignale mit einer hohen Frequenz, beispielsweise mehr als 10 GHz, mehr als 20 GHz oder mehr als 40 GHz zuverlässig zu digitalisieren, wird erfindungsgemäß vorgeschlagen, dass der Analog-Digital-Konverter eine optische Eingangsstufe aufweist, welche dazu eingerichtet ist, das analoge Eingangssignal in ein phasenmoduliertes optisches Signal zu wandeln. Hierzu kann die optische Eingangsstufe zumindest einen Lokaloszillator enthalten, welcher Laserstrahlung vorgebbarer Wellenlänge bzw. Frequenz aussendet. Das vom Lokaloszillator erzeugte Licht kann in einen Signalpfad und einen Referenzpfad aufgeteilt werden. Durch Änderung der Laufzeit des Lichtes im Signalpfad in Abhängigkeit der analogen Eingangsgröße kann eine Phasenverschiebung zwischen dem optischen Signal im Signalpfad und dem Referenzpfad erfolgen, welche von der Amplitude des analogen Eingangssignals abhängt.

Das phasenmodulierte optische Signal wird zumindest einem Hybridkoppler mit einer Mehrzahl von Eingangswellenleitern und einer Mehrzahl von Ausgangswellenleitern zugeführt. In Abhängigkeit der Phasendifferenz der Eingangssignale wird die in den Hydridkoppler eingekoppelte optische Leistung auf die Ausgangswellenleiter verteilt. Somit steht an jedem Ausgang des Hybridkopplers ein amplitudenmoduliertes, analoges optisches Signal zur Verfügung, welches die Information des analogen elektrischen Eingangssignals trägt. Weiter wird nun das optische Signal von zumindest zwei Ausgangswellenleitern mit jeweils zumindest einer Photodiode in ein elektrisches Signal gewandelt. In einigen Ausführungsformen der Erfindung können sämtliche Ausgangswellenleiter mit zugeordneten Photodioden verbunden sein, so dass sämtliche Ausgangssignale des Hydridkopplers weiterverarbeitet werden. Hierdurch können die Auflösung und/oder die Grenzfrequenz des erfindungsgemäßen Analog-Digital-Konverters erhöht sein.

Die elektrischen Anschlusskontakte der Photodioden sind jeweils mit dem Eingang eines an sich bekannten elektronischen Analog-Digital-Wandlers verbunden. In einigen Ausführungsformen der Erfindung kann zwischen dem Ausgang der Photodiode und dem Eingang des Analog-Digital-Wandlers ein Abtast-Halte-Glied angeordnet sein, welches es erlaubt, das analoge Ausgangssignal der Photodiode kurzzeitig auf einen definierten Wert zu halten, welcher zu einem vorgebbaren Zeitpunkt am Ausgang der Photodiode bereitgestellt wurde. Hierdurch kann die Quantisierung der Amplitude im nachfolgenden Analog-Digital-Wandler auch bei schnellen Änderungen des optischen Eingangssignals mit großer Genauigkeit durchgeführt werden. In einigen Ausführungsformen der Erfindung können der Analog-Digital-Wandler und das Abtast-Halte-Glied in einen Baustein integriert sein, wodurch ein niedriger Preis, ein geringer Platzbedarf und eine gemeinsame Spezifikation beider Komponenten gewährleistet sind. Sofern sich das analoge Eingangssignal verglichen mit der Konversionsdauer der Analog-Digital-Wandler nur langsam ändert, kann in einigen Ausführungsformen der Erfindung auf das Abtast-Halte-Glied verzichtet werden.

Am Ausgang des Analog-Digital-Wandlers steht ein digitales elektrisches Ausgangssignal zur Verfügung, welches das analoge Eingangssignal des Analog-Digital-Konverters repräsentiert. Da zumindest zwei Analog-Digital-Wandler eingesetzt werden, bevorzugt jedoch eine der Anzahl der Ausgangswellenleiter des Hybridkopplers entsprechende Anzahl von Analog-Digital-Wandlern, steht das digitale Ausgangssignal mehrfach zur Verfügung.

Die digitalen Ausgangssignale werden einer Ausgangsstufe zugeführt, welche aus den Signalen der Analog-Digital-Wandler das digitale Ausgangssignal des Analog-Digital-Konverters bilden. Hierzu wählt die Ausgangsstufe für jeden Wertebereich des analogen Eingangssignals das Ausgangssignal eines Analog-Digital-Wandlers aus. Da somit jeder Analog-Digital-Wandler nur einen Teilbereich der Eingangsamplitude diskretisieren muss, erhöht sich die Auflösung der gesamten Anordnung mit einer Mehrzahl von parallel geschalteten Digital-Analog-Wandlern.

In einigen Ausführungsformen der Erfindung kann die optische Eingangsstufe zumindest einen Mach-Zehnder-Modulator enthalten. Der Mach-Zehnder-Modulator kann in einigen Ausführungsformen einen Schmelzkoppler enthalten, um eingekoppeltes Licht eines Lasers in einem Referenzpfad und einen Signalpfad aufzuteilen. Das Licht des Referenzpfads kann den Mach-Zehnder-Modulator im Wesentlichen unverändert verlassen. Die elektrische Spannung des analogen Eingangssignals kann so auf einen Teilabschnitt des Signalpfads einwirken, dass sich der Brechungsindex des Wellenleiters in Abhängigkeit der anliegenden Spannung ändert. Hierdurch entsteht eine Phasenverschiebung des im Signalpfad geführten optischen Signals. Somit kann am Ausgang des Mach-Zehnder-Modulators ein analoges optisches phasenmoduliertes Signal erzeugt werden, welches die Information des analogen Eingangssignals trägt.

In einigen Ausführungsformen der Erfindung kann der als Lokaloszillator verwendete Laser zumindest eine Laserdiode sein. Eine solche Laserdiode ist einfach betreibbar, mechanisch robust und aufgrund ihrer geringen Baugröße einfach in den Analog-Digital-Konverter integrierbar.

In einigen Ausführungsformen der Erfindung kann der verwendete Laser im Dauerstrichbetrieb betreibbar sein. Hierdurch kann das kontinuierlich veränderliche analoge elektrische Eingangssignal in ein kontinuierliches optisches Signal überführt werden, so dass es zu keinerlei Informationsverlust kommt.

In einigen Ausführungsformen der Erfindung kann der verwendete Laser im Pulsbetrieb betreibbar sein. In einigen Ausführungsformen der Erfindung kann der Laser Pulsbreiten von weniger als einer Nanosekunde oder weniger als einer Pikosekunde oder weniger als 100 Femtosekunden erzeugen. Diese Laserpulse können Amplitudenmoduliert werden, so dass der zeitliche Abstand der Einzelpulse die Diskretisierung der Zeitachse darstellt und die Amplitude des Eingangssignals als Amplitudenvariation der Einzelpulse auf dem optischen Trägersignal kodiert ist. Aufgrund der hohen Zeitkonstanz des Lasers kann die Diskretisierung der Zeitachse in dieser Ausführungsform mit hoher Frequenz erfolgen, so dass es durch Multiplexen zu einer Erhöhung der Bandbreite kommen kann.

In einigen Ausführungsformen der Erfindung kann die Anzahl der Ausgangswellenleiter des Hybridkopplers 2^{Q} betragen. In einigen Ausführungsformen der Erfindung kann Q ganzzahlig sein und aus dem Intervall von 1 bis 4 gewählt werden. Dies stellt sicher, dass eine hinreichende Anzahl von parallelen Signalpfaden zum Betrieb der parallelen Analog-Digital-Wandler zur Verfügung steht und die Signale einfach zum Ausgangssignal des Analog-Digital-Konverters zusammengefügt werden können.

In einigen Ausführungsformen der Erfindung wählt die Ausgangsstufe in Abhängigkeit der Phasendifferenz des Eingangssignals des Hybridkopplers das Ausgangssignal eines zugeordneten Analog-Digital-Wandlers aus, um dieses als Ausgangssignal des Analog-Digital-Konverters bereitzustellen. Hierdurch kann die Auswahl in einfacher Weise durch einen digitalen Signalprozessor oder eine Umsetzungstabelle erfolgen, so dass die Auswahl auch bei hoher Datenrate bzw. Eingangssignalen mit hoher Grenzfrequenz zuverlässig erfolgen kann. Da jeder Analog-Digital-Wandler nur einen Teil der gesamten Signalamplitude bzw. des gesamten Bereichs der Phasenverschiebung verarbeiten muss, ist die Auflösung des Analog-Digital-Konverters erhöht.
In einigen Ausführungsformen der Erfindung ist die Ausgangsstufe dazu eingerichtet, das Ausgangssignal des Analog-Digital-Wandlers auszuwählen, welches innerhalb eines vorgebbaren Bereichs der Amplitude liegt und eine positive Steigung aufweist und/oder größer ist als ein vorgebbares benachbartes Ausgangssignal. Durch die Beschränkung auf einen vorgebbaren Bereich der Amplitude kann das Ausgangssignal des Hybridkopplers auf die näherungsweise linearen Abschnitte der Sinuskurven beschränkt werden. Hierdurch kann eine aufwändige Entzerrung des digitalen Ausgangssignals entfallen. Da bei einer größeren Anzahl von Ausgangssignalen des Hybridkopplers unter Umständen eine Mehrzahl von Ausgangssignalen im gewünschten Bereich der Amplitude liegt, kann durch ein weiteres Auswahlkriterium eines der Ausgangssignale ausgewählt werden. Beispielsweise kann stets die Kurve mit positiver Steigung gewählt werden oder stets die Kurve mit negativer Steigung. Zusätzlich oder alternativ kann als weiteres Auswahlkriterium herangezogen werden, dass dasjenige Ausgangssignal ausgewählt wird, welches größer ist als ein vorgebbares benachbartes Ausgangssignal. Beispielsweise kann stets das rechts benachbarte Signal ausgewählt werden. Die Ober- und Untergrenze der Amplitude sowie die auszuwählende Steigung und/oder das mit einem vorausgewählten Ausgangssignal zu vergleichende Ausgangssignal können in einer Tabelle hinterlegt werden, so dass die Auswahl durch einen digitalen Signalprozessor oder ggf. auch durch einen Mikrokontroller schnell und einfach erfolgen kann. Aufwändige Berechnungen zur Auswahl des richtigen Signals müssen somit während des Betriebes des Analog-Digital-Konverters nicht mehr angestellt werden, so dass die maximale Arbeitsfrequenz erhöht sein kann.

In einigen Ausführungsformen der Erfindung kann der Hybridkoppler 2^{Q} Ausgangswellenleiter aufweisen und jeder der parallelen Analog-Digital-Wandler eine Auflösung von jeweils P Bit. In diesem Fall kann der Analog-Digital-Konverter so betrieben werden, dass das analoge Eingangssignal an dessen Ausgang mit einer Auflösung von (P+Q) Bit zur Verfügung gestellt werden kann. Weist jeder der Analog-Digital-Wandler beispielsweise eine Auflösung von 10 Bit auf, so kann durch die Verwendung von zwei parallelen Analog-Digital-Wandlern eine Auflösung von 11 Bit erzielt werden. Durch die Verwendung von 8 parallelen Analog-Digital-Wandlern kann eine Auflösung von 13 Bit erzielt werden.

Nachfolgend soll die Erfindung anhand von Figuren ohne Beschränkung des allgemeinen Erfindungsgedankens näher erläutert werden. Dabei zeigt
Fig. 1 ein Blockschaltbild einer Ausführungsform der vorliegenden Erfindung.
Fig. 2 zeigt den Aufbau der optischen Eingangsstufe.
Fig. 3 zeigt beispielhaft die Ausgangssignale der Photodioden der optischen Eingangsstufe für einen Hybridkoppler mit vier Ausgängen.
Fig. 4 zeigt beispielhaft den Ausgang der Photodioden für einen Hybridkoppler mit acht Ausgängen.
Fig. 5 zeigt ein Flussdiagramm des erfindungsgemäßen Verfahrens.

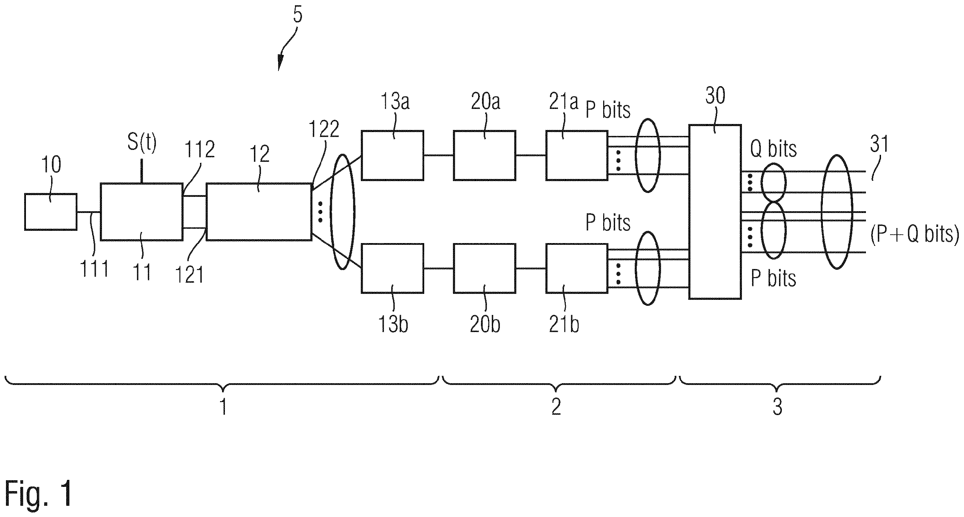

Fig. 1 zeigt ein Blockschaltbild einer Ausführungsform der vorliegenden Erfindung. Der vorgeschlagene Analog-Digital-Konverter weist eine optische Eingangsstufe 1 auf. Die Ausgänge der optischen Eingangsstufe 1 sind mit den entsprechenden Eingängen einer Analog-Digital-Wandlerstufe 2 verbunden. Deren Ausgänge werden einer Ausgangsstufe 3 zugeführt. Der Ausgang 31 der Ausgangsstufe 3 bildet den Ausgang des vorgeschlagenen Analog-Digital-Konverters.

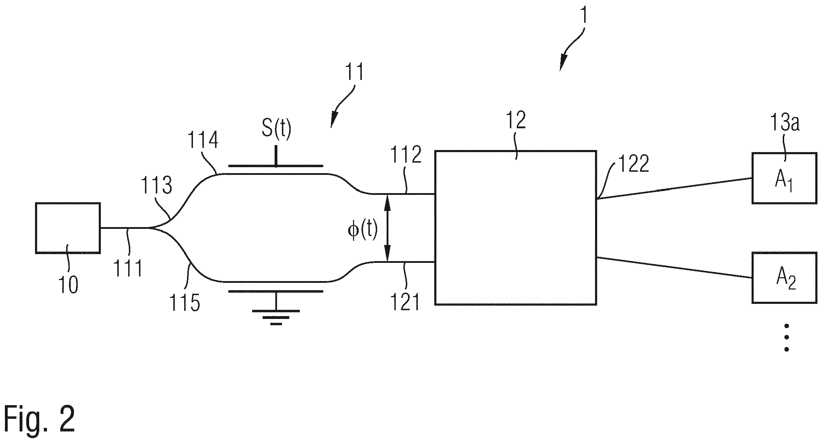

Die optische Eingangsstufe 1 wird nachfolgend anhand der Fig. 1 und 2 beschrieben. Die Eingangsstufe 1 weist einen Laser 10 auf, welcher als Lokaloszillator ein optisches Trägersignal bereitstellt. In einigen Ausführungsformen der Erfindung kann der Laser 10 eine Laserdiode sein oder eine solche enthalten. In einigen Ausführungsformen der Erfindung kann der Laser 10 im Dauerstrichbetrieb arbeiten und auf diese Weise ein zeitlich konstantes optisches Signal bereitstellen.

Das Licht des Lasers 10 wird über einen Wellenleiter einem Mach-Zehnder-Modulator 11 zugeführt. Der Mach-Zehnder-Modulator 11 weist einen optischen Eingang 111 und zwei optische Ausgänge 112 auf. Weiterhin weist der Mach-Zehnder-Modulator 11 zumindest einen elektrischen Eingang auf, welchem zumindest ein analoges Eingangssignal S(t) zugeführt werden kann.

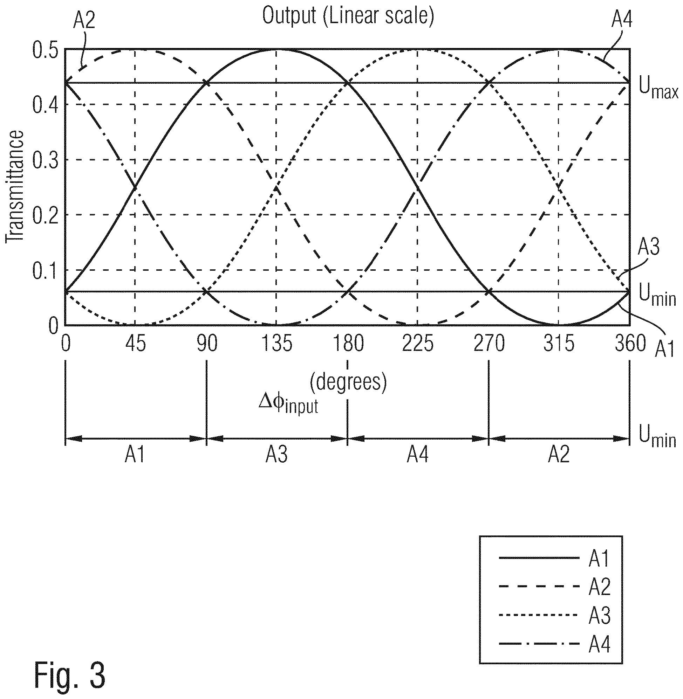

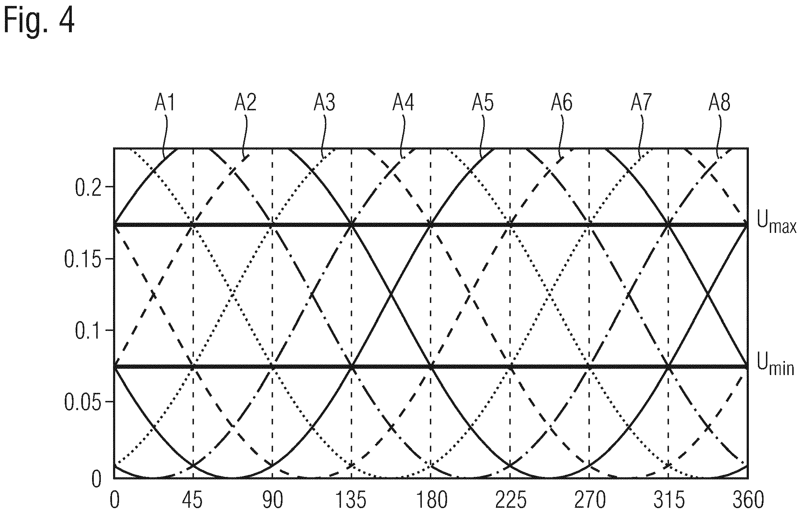

Wie anhand von Fig. 2 ersichtlich ist, ist der optische Eingang 111 mit einem Koppler 113 verbunden. Der Koppler 113 kann beispielsweise ein Schmelzkoppler zwischen zwei Wellenleitern sein oder ein an sich bekannter 3dB-Koppler oder ein Hybridkoppler. Wesentlich für die Funktion des Modulators ist, dass das optische Trägersignal des Lasers 10 auf einen Signalpfad 112 und einen Referenzpfad 115 aufgeteilt wird. Der im Referenzpfad 115 geführte Anteil des Laserlichts verlässt den Modulator 11 im Wesentlichen unverändert. Durch die elektrische Spannung des analogen Eingangssignals S(t) wird der Brechungsindex eines Teilabschnittes des Signalspfades 114 in Abhängigkeit der anliegenden Spannung geändert, so dass sich eine Phasenverschiebung des Lichts zwischen Referenzpfad 115 und Signalpfad 114 einstellt. An den Ausgängen 112 steht somit ein phasenmoduliertes analoges optisches Signal zur Verfügung, welches die Informationen des elektrischen Eingangssignals S(t) trägt.
Die Ausgänge 112 des Modulators 11 werden entsprechenden Eingängen des Hybridkopplers 12 zugeführt. Der Hybridkoppler 12 kann 2^{Q} Ausgänge 122 aufweisen. Beispielsweise kann die Anzahl der Ausgänge 122 2, 4, 8 oder 16 betragen. Dementsprechend beträgt die Anzahl der Eingänge 121 ebenfalls in der Regel 2, 4, 8 oder 16. Sofern mehr als zwei Eingänge 121 zur Verfügung stehen, werden zwei dieser Eingänge ausgewählt, um die Signale der Ausgänge 112 des Modulators 11 aufzunehmen. Die übrigen Eingänge 121 können in diesem Fall unverschaltet bleiben.
Der Hybridkoppler 12 ist dazu eingerichtet, die an seinem Eingang bereitgestellten Signale des Modulators 11 in die Mehrzahl von Ausgangswellenleitern 122 zu überführen. Dabei ändert sich die Intensität an den einzelnen Ausgängen 122 in Abhängigkeit der Phasenbeziehung der Eingangssignale am Eingang 121. Somit transformiert der Hybridkoppler das phasenmodulierte Signal an seinem Eingang in eine Mehrzahl von amplitudenmodulierten Signalen an seinem Ausgang.
Ein Beispiel für vier Ausgangssignale eines Hybridkopplers mit vier Ausgangswellenleitern 122 ist in Fig. 3 gezeigt. Ein weiteres Beispiel für acht Ausgangssignale eines Hybridkopplers mit acht Ausgangswellenleitern zeigt Fig. 4. Aufgetragen ist in Fig. 3 und 4 jeweils der Betrag der Phasenverschiebung von 0 bis 360° auf der Abszisse und die Intensität der Ausgangssignale auf der Ordinate. Die Intensität des an den jeweiligen Ausgängen ausgekoppelten Lichtes variiert in Form einer trigonometrischen Funktion bzw. einer Sinusfunktion mit der Phasenverschiebung. Dabei sind diese trigonometrischen Funktionen unterschiedlicher Ausgänge um jeweils ein Viertel bzw. ein Achtel des gesamten Winkelbereiches verschoben. Wie aus Fig. 3 ersichtlich ist, erreicht beispielsweise der Ausgang A2 für eine Phasenverschiebung von 45° seinen maximalen Ausgangswert und für eine Phasenverschiebung von 225° den minimalen Ausgangswert. Der Ausgang A1 weist hierzu 90° Phasenverschiebung auf, d.h. das Maximum der Intensität wird bei einer Phasenverschiebung der Eingangssignale von 135° erreicht und das Minimum bei 315°. Die Ausgangsintensität des Ausgangs A3 ist um 180° phasenverschoben zu A2, d.h. die maximale Intensität liegt bei einer Phasenverschiebung der Eingangssignale von 225 ° an und die minimale Intensität bei 45 °. Gleiches gilt analog für das in Fig. 4 gezeigte Ausführungsbeispiel mit 8 Ausgangswellenleitern. Die anhand der Figuren 3 und 4 dargestellten Prinzipien können leicht auf einen Hybridkoppler mit mehr oder weniger Ausgängen übertragen werden. Die Ausgangswellenleiter 122 des Hybridkopplers 12 sind mit jeweils einer zugeordneten Photodiode 13a, 13b, ... verbunden. Aus Gründen der Übersichtlichkeit sind in den Fig. 1 und 2 nur zwei Photodioden dargestellt. Die Photodioden 13a und 13b dienen dazu, die optischen Signale aus den Wellenleitern 122 in elektrische Signale zu wandeln. Hierzu kann in einigen Ausführungsformen der Erfindung auch mehr als eine Photodiode pro Wellenleiter zur Verfügung stehen, beispielsweise um positive oder negative Halbwellen separat zu konvertieren oder um die Ausgangsspannung zu erhöhen oder um die erhaltenen Signale zu plausibilisieren.

Die Ausgänge der Photodioden 13 bilden gleichzeitig den Ausgang der optischen Eingangsstufe 1.

Die optische Eingangsstufe 1 ist mit einer Analog-Digital-Stufe 2 verbunden. Die Analog-Digital-Stufe 2 entspricht einer Mehrzahl von an sich bekannten elektronischen Analog-Digital-Wandlern 21a und 21b, welchen das Ausgangssignal der Photodioden 13 entweder direkt zugeführt wird oder mittels jeweils eines zugeordneten optionalen Abtast-Halte-Glieds 20a und 20b. Auf diese Weise kann das elektrische analoge Ausgangssignal der Photodioden 13 in an sich bekannter Weise in einen digitalen Datenstrom am Ausgang der Analog-Digital-Wandler 21 gewandelt werden.

Wie aus Fig. 1 ersichtlich ist, wird jeder Photodiode 13a, 13b ein Analog-Digital-Wandler 21a, 21b und ein optionales Abtast-Halte-Glied 20a, 20b zugeordnet. Auf diese Weise werden die 2^{Q} analogen Signale in eine entsprechende Anzahl digitaler Datenströme übersetzt, welche jeweils mit einer Auflösung von P Bits diskretisiert sind, welche durch die Eigenschaften der elektronischen Analog-Digital-Wandler gegeben sind.

Die digitalen Ausgänge der Analog-Digital-Wandler 21 bilden gleichzeitig den Ausgang der Analog-Digital-Stufe 2. Der Ausgang der Analog-Digital-Stufe 2 ist mit dem Eingang einer Ausgangsstufe 3 verbunden. Die Ausgangsstufe 3 ist dazu eingerichtet, aus den digitalen Ausgangssignalen der Analog-Digital-Wandler 21a, 21b den digitalen Datenstrom am Ausgang 31 des Analog-Digital-Konverters 5 zu bilden. Hierzu weist die Ausgangsstufe 3 eine Auswahleinrichtung auf, welche aus der Mehrzahl von digitalen Eingangssignalen zu jedem diskreten Zeitschritt eines auswählt, welches das Ausgangssignal 31 bildet. Hierzu enthält die Ausgangsstufe 3 zumindest eine einfache Auswahlregel, mit welcher aus der Mehrzahl von digitalen Datenströmen einer ausgewählt werden kann. Die Auswahl kann beispielsweise mittels einer Umsetztabelle und eines digitalen Signalsprozessors erfolgen, so dass der erfindungsgemäße Analog-Digital-Konverter eine geringe Latenzzeit und eine hohe obere Grenzfrequenz aufweist.

Ein Beispiel einer solchen Auswahlregel wird anhand von Fig. 3 näher erläutert. Gemäß dem Ausführungsbeispiel der Fig. 3 wird als erste Auswahlregel die Amplitude zwischen einem Minimalwert und einem Maximalwert Uₘᵢₙ bzw. Uₘₐₓ begrenzt. Messwerte, welche außerhalb dieses Amplitudenbereichs liegen, werden verworfen. Hierdurch kann die Signalauslese auf den näherungsweise linearen Abschnitt der trigonometrischen Funktionen begrenzt werden, so dass eine aufwändige Entfaltung der Messwerte vermieden werden kann. Sofern eine Begrenzung auf einen engen Amplitudenbereich nicht möglich ist, beispielsweise weil nur zwei optische Ausgangssignale zur Verfügung stehen, kann selbstverständlich auch eine Entfaltung der nichtlinear verzerrten Signale mittels des digitalen Signalprozessors der Ausgangsstufe 3 erfolgen.

Nach der Diskriminierung der Signale auf den vorgebbaren Amplitudenbereich wird als nachrangiges Kriterium die positive Steigung des Ausgangssignals herangezogen. Dies kann entweder unmittelbar durch Bestimmung der Steigung erfolgen oder durch Vergleich des vorausgewählten Ausgangssignals mit dem im Diagramm der Fig. 3 nächstgelegenen rechten Ausgangssignal. Somit wird für Phasenverschiebungen zwischen 0 und 90° der Ausgang A1 zur Bestimmung des digitalen Ausgangswertes herangezogen. Für Phasenverschiebungen zwischen 90 und 180° wird der Ausgang A3 herangezogen. Für Phasenverschiebungen zwischen 180 und 270° wird der Ausgang A4 herangezogen und für Phasenverschiebungen zwischen 270 und 360° der Ausgang A2.

Das Grundprinzip der Erfindung beruht darauf, dass die Amplitude des analogen Eingangssignals in der Eingangsstufe 1 auf einen Bereich der Phasenverschiebung von 0° bis 360° abgebildet wird, jeder Analog-Digital-Wandler jedoch nur einen Teilbereich verarbeiten muss, so dass für den gesamten Amplitudenbereich mehrere Analog-Digital-Wandler zur Verfügung stehen, welche zusammen eine höhere Auflösung bieten.

Die vorstehend erläuterten Auswahlregeln werden nachfolgend nochmals anhand von Beispielen erläutert. Im ersten Beispiel weist das analoge Eingangssignal S(t) eine elektrische Spannung auf, welche im phasenmodulierten Ausgangssignal am Ausgang 112 des Modulators 11 eine Phasenverschiebung von 50° bewirkt. Wie aus Fig. 3 ersichtlich ist, liegen bei einer Phasenverschiebung von 50° lediglich die Ausgangswerte der Ausgänge A4 und A1 im voreingestellten Amplitudenbereich zwischen Uₘᵢₙ und Uₘₐₓ. Die Ausgänge A2 und A3 können somit verworfen werden. Sofern nachfolgend die Steigung der Ausgangsspannungsverläufe ermittelt wird und eine positive Steigung als Auswahlkriterium festgelegt ist, kann der Ausgang A4 verworfen werden und der vom Ausgang A1 gelieferte digitale Wert bildet den Ausgangswert des Analog-Digital-Konverters in diesem Zeitschritt.

Alternativ oder zusätzlich kann statt der Steigung auch ein Vergleich der Ausgangswerte mit den jeweils nächsten Nachbarn erfolgen. Somit wird der am Ausgang A4 anliegende Wert mit dem Wert des Ausgangs A2 verglichen. Dieser Vergleich ergibt, dass A4 bei einer Phasenverschiebung von 50° eine geringere Amplitude aufweist als A2. Daher wird A4 verworfen, da stets der größere Wert zu wählen ist, A2 jedoch bereits im ersten Auswahlschritt verworfen wurde. Alternativ oder zusätzlich kann auch A1 mit A3 verglichen werden. Dieser Vergleich ergibt, dass A1 die größere Amplitude aufweist. Daher wird A1 als zutreffender Ausgang gewählt.

Im zweiten Beispiel soll das analoge Eingangssignal S(t) eine Phasenverschiebung von 230° bewirken. Auch in diesem Fall ergibt das Amplitudenkriterium wieder eine Auswahl zwischen A4 oder A1. Der Vergleich von A4 mit A2 ergibt, dass A4 die größere Amplitude aufweist und damit zutreffend ist. Der Vergleich zwischen A1 und A3 ergibt, dass A1 eine geringere Amplitude aufweist. Daher wird A1 verworfen.

In gleicher Weise wie vorstehend für 4 Ausgangssignale A1 bis A4 beschrieben, können dieselben Auswahlkriterien auch auf einen Hybridkoppler mit 8 Ausgängen angewendet werden, wie anhand von Fig. 4 dargestellt ist. Auch in diesem Fall muss zumindest ein im ersten Schritt vorausgewähltes Signal mit seinem jeweils nächsten Nachbarn verglichen werden, wie anhand nachfolgender Tabelle dargestellt ist:

| vorausgewähltes Signal | Vergleichssignal |
|---|---|
| A1 | A2 |
| A2 | A3 |
| A3 | A4 |
| A4 | A5 |
| A5 | A6 |
| A6 | A7 |
| A7 | A8 |
| A8 | A1 |

Wie aus Fig. 4 weiterhin ersichtlich ist, können die Grenzen des Amplitudenbereichs Uₘᵢₙ bis Uₘₐₓ enger gewählt werden, wenn mehrere Ausgangssignale zur Verfügung stehen. Hierdurch ergibt sich eine verbesserte Annäherung der trigonometrischen Funktionen an Polynome erster Ordnung so dass der bei der Auslese erzeugte Fehler geringer wird.

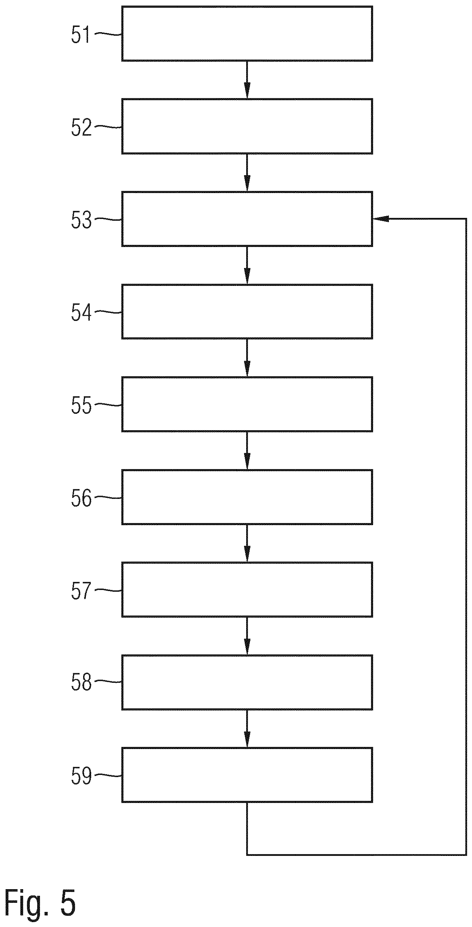

Fig. 5 erläutert nochmals ein Flussdiagramm des erfindungsgemäßen Verfahrens. Im ersten Verfahrensschritt 51 wird ein optisches Trägersignal mittels eines Lasers bereitgestellt. Im zweiten Verfahrensschritt 52 wird dieses Trägersignal in einen Referenzpfad und einen Signalpfad aufgeteilt.

Nachfolgend erfolgt im dritten Verfahrensschritt 53 die Modulation des optischen Trägerpfades im Signalpfad, so dass am Ausgang des Modulators ein phasenmoduliertes analoges optisches Signal zur Verfügung steht, welches das elektrische analoge Eingangssignal repräsentiert.

Das phasenmodulierte optische Signal wird im Schritt 54 einem Hybridkoppler mit einer Mehrzahl von Eingängen und einer Mehrzahl von Ausgängen zugeführt. Hierdurch wird das phasenmodulierte Signal in eine Mehrzahl von Ausgangswellenleitern eingekoppelt, wobei die Intensität des optischen Signals in unterschiedlichen Ausgangswellenleitern in Abhängigkeit der Phase unterschiedlich ist.

Im Verfahrensschritt 55 wird diese Mehrzahl optischer Signale in elektrische Signale gewandelt, beispielsweise mittels jeweils zumindest einer zugeordneten Photodiode.

Die im Verfahrensschritt 55 erhaltenen elektrischen Signale werden im Verfahrensschritt 56 einem Analog-Digital-Wandler zugeführt, welcher die elektrischen Signale in an sich bekannter Weise mit vorgebbarer Auflösung digitalisiert. Die Ausgangssignale der Analog-Digital-Wandler werden der Ausgangsstufe 3 zugeführt.

Die Ausgangsstufe 3 führt eine Auswahl der digitalen Signale durch. Hierzu wird im Verfahrensschritt 57 eine Diskriminierung der Signale nach der Amplitude durchgeführt, so dass Ausgangssignale mit einer geringeren Amplitude als Uₘᵢₙ verworfen werden und Ausgangssignale mit einer Amplitude oberhalb von Uₘₐₓ ebenfalls verworfen werden. Die danach verbleibenden Ausgangssignale werden im Verfahrensschritt 58 weiterhin nach der Steigung diskriminiert, beispielsweise können nur Signale mit positiver Steigung als gültig anerkannt werden. Das so ausgewählte digitale Signal wird im Verfahrensschritt 59 als Ausgangssignal 31 bereitgestellt. Nachfolgend läuft das Verfahren ab Verfahrensschritt 53 erneut ab, so dass mit jedem vollständigem Durchlauf ein diskreter digitaler Wert ausgegeben wird, welcher das analoge Eingangssignal S(t) zum jeweiligen Zeitpunkt repräsentiert.

Selbstverständlich ist die Erfindung nicht auf die in den Figuren dargestellten Ausführungsformen beschränkt. Die vorstehende Beschreibung ist daher nicht als beschränkend, sondern als erläuternd anzusehen. Die nachfolgenden Ansprüche sind so zu verstehen, dass ein genanntes Merkmal in zumindest einer Ausführungsform der Erfindung vorhanden ist. Dies schließt die Anwesenheit weiterer Merkmale nicht aus.

## Patentansprüche

1. Analog-Digital-Konverter (5) mit zumindest einem Eingang, welchem zumindest ein analoges Eingangssignal (S(t)) zuführbar ist und mit zumindest einem Ausgang (31), welcher dazu eingerichtet ist, einen digitalen Datenstrom auszugeben, welcher das analoge Eingangssignal
repräsentiert, wobei
der Analog-Digital-Konverter eine optische Eingangsstufe (1) aufweist, welche dazu eingerichtet ist, das analoge Eingangssignal (S(t)) in ein phasenmoduliertes optisches Signal zu wandeln und dieses einem Hybridkoppler (12) mit einer Mehrzahl von Ausgangswellenleitern (122) zuzuführen, welche mit jeweils zumindest einer Photodiode (13a, 13b) verbunden sind,
die elektrischen Anschlusskontakte der Photodioden (13a, 13b) jeweils mit dem Eingang eines zugeordneten Analog-Digital-Wandlers (21a, 21b) verbunden sind, mit welchen ein analoges elektrisches Eingangssignal in ein digitales elektrisches Ausgangssignal umsetzbar ist, und
der Ausgang der Analog-Digital-Wandler (21a, 21b) mit den Eingängen einer Ausgangsstufe (3) verbunden sind, welche dazu eingerichtet ist, aus den digitalen Ausgangssignalen der Analog-Digital-Wandler (21a, 21b) den digitalen Datenstrom am Ausgang (31) zu bilden, **dadurch gekennzeichnet, dass**
die Ausgangsstufe (3) dazu eingerichtet ist, das Ausgangssignal des Analog-Digital-Wandlers (21a, 21b) auszuwählen, welches innerhalb eines vorgebbaren Bereiches der Amplitude liegt und als nachrangiges Kriterium eine vorgebbare Steigung aufweist und/oder größer ist als ein vorgebbares benachbartes Ausgangssignal.

2. Analog-Digital-Konverter nach Anspruch 1, wobei die optische Eingangsstufe (1) zumindest einen Mach-Zehnder-Modulator (11) und zumindest einen Laser (10) enthält.

3. Analog-Digital-Konverter nach Anspruch 2, wobei der Laser (10) im Pulsbetrieb betreibbar ist.

4. Analog-Digital-Konverter nach Anspruch 2, wobei der Laser (10) im Dauerstrichbetrieb betreibbar ist.

5. Analog-Digital-Konverter nach einem der Ansprüche 1 bis 4, wobei der Hybridkoppler (12) 2^{Q} Ausgangswellenleiter aufweist und/oder dass der Hybridkoppler einen 2x2- oder ein 4x4- oder ein 8x8-Multimode-Interferenzkoppler aufweist.

6. Analog-Digital-Konverter nach einem der Ansprüche 1 bis 5, wobei der Hybridkoppler (12) dazu eingerichtet ist, Eingangssignale unterschiedlicher Phase mit unterschiedlicher Intensität in die Ausgangswellenleiter einzukoppeln.

7. Analog-Digital-Konverter nach einem der Ansprüche 1 bis 6, wobei die Ausgangsstufe (3) dazu eingerichtet ist, in Abhängigkeit der Phasendifferenz der Signale am Eingang des Hybridkopplers (12) das Ausgangssignal eines Analog-Digital-Wandlers (21a, 21b) auszuwählen und als Ausgangssignal des Analog-Digital-Konverters (5) am Ausgang (31) bereit zu stellen.

8. Analog-Digital-Konverter nach einem der Ansprüche 1 bis 7, wobei die Ausgangsstufe (3) einen digitalen Signalprozessor (30) und/oder eine Umsetzungstabelle aufweist.

9. Analog-Digital-Konverter nach einem der Ansprüche 1 bis 8, wobei der Hybridkoppler (12) 2^{Q} Ausgangswellenleiter aufweist und die Analog-Digital-Wandler (21a, 21b) eine Auflösung von jeweils P Bit aufweisen und das analoge Eingangssignal am Ausgang (31) des Analog-Digital-Konverters (5) mit einer Auflösung von (P+Q) Bits zur Verfügung gestellt werden kann.

10. Verfahren zum Erzeugen eines digitalen Datenstromes, welcher ein analoges Eingangssignal repräsentiert,
wobei das analoge Eingangssignal (S(t)) in ein phasenmoduliertes optisches Signal gewandelt wird und dieses einem Hybridkoppler (12) mit einer Mehrzahl von Ausgangswellenleitern (122) zugeführt wird, welche mit jeweils zumindest einer Photodiode (13a, 13b) verbunden sind,
die elektrischen Ausgangssignale der Photodioden (13a, 13b) jeweils dem Eingang eines zugeordneten Analog-Digital-Wandlers (21a, 21b) zugeführt wird, mit welchen ein analoges elektrisches Eingangssignal in ein digitales elektrisches Ausgangssignal umgesetzt wird, **dadurch gekennzeichnet, dass**
aus den digitalen Ausgangssignalen der Analog-Digital-Wandler (21a, 21b) eines ausgewählt wird, um den digitalen Datenstrom zu bilden, wobei das Ausgangssignal des Analog-Digital-Wandlers (21a, 21b) ausgewählt wird, welches innerhalb eines vorgebbaren Bereiches der Amplitude liegt und als nachrangiges Kriterium eine positive Steigung aufweist und/oder größer ist als ein vorgebbares benachbartes Ausgangssignal.

11. Verfahren nach Anspruch 10, wobei der Laser im Dauerstrichbetrieb betrieben wird.

12. Verfahren nach einem der Ansprüche 10 oder 11, wobei Eingangssignale unterschiedlicher Phase mit unterschiedlicher Intensität in die 2^{Q} Ausgangswellenleiter des Hybridkopplers (12) eingekoppelt werden.

## Claims

1. Analog-digital converter (5) having at least one input to which at least one analog input signal (S(t)) can be supplied and having at least one output (31), which is configured to output a digital data stream representing the analog input signal, wherein
the analog-digital converter comprises an optical input stage (1), which is configured to convert the analog input signal (S(t)) into a phase-modulated optical signal and supply it to a hybrid coupler (12) with a plurality of output waveguides (122), each connected to at least one photodiode (13a, 13b),
the electrical terminal contacts of the photodiodes (13a, 13b) are each connected to the input of an associated analog-digital converter (21a, 21b), by means of which an analog electrical input signal can be converted into a digital electrical output signal, and
the output of the analog-digital converters (21a, 21b) is connected to the inputs of an output stage (3), which is configured to form the digital data stream at the output (31) from the digital output signals of the analog-digital converters (21a, 21b), **characterized in that**
the output stage (3) is configured to select the output signal of the analog-digital converter (21a, 21b) that is within a predeterminable range of the amplitude and, as a criterion of lower priority, has a predeterminable slope and/or is greater than a predeterminable adjacent output signal.

2. Analog-digital converter according to claim 1, wherein the optical input stage (1) contains at least one Mach-Zehnder modulator (11) and at least one laser (10).

3. Analog-digital converter according to claim 2, wherein the laser (10) can be operated in pulsed mode.

4. Analog-digital converter according to claim 2, wherein the laser (10) can be operated in continuous-wave mode.

5. Analog-digital converter according to any of claims 1 to 4, wherein the hybrid coupler (12) has 2^{Q} output waveguides and/or wherein the hybrid coupler has a 2x2 or a 4x4 or an 8x8 multimode interference coupler.

6. Analog-to-digital converter according to any of claims 1 to 5, wherein the hybrid coupler (12) is configured to couple input signals of different phase with different intensity into the output waveguides.

7. Analog-digital converter according to any of claims 1 to 6, wherein the output stage (3) is configured to select the output signal of an analog-digital converter (21a, 21b) on the basis of the phase difference of the signals at the input of the hybrid coupler (12) and to provide it as the output signal of the analog-digital converter (5) at the output (31).

8. Analog-digital converter according to any of claims 1 to 7, wherein the output stage (3) comprises a digital signal processor (30) and/or a conversion table.

9. Analog-digital converter according to any of claims 1 to 8, wherein the hybrid coupler (12) has 2^{Q} output waveguides and the analog-digital converters (21a, 21b) have a resolution of P bits each and the analog input signal can be made available at the output (31) of the analog-digital converter (5) with a resolution of (P+Q) bits.

10. Method for generating a digital data stream representing an analog input signal, wherein the analog input signal (S(t)) is converted into a phase-modulated optical signal which is supplied to a hybrid coupler (12) with a plurality of output waveguides (122), each connected to at least one photodiode (13a, 13b),
the electrical output signals of the photodiodes (13a, 13b) are each supplied to the input of an associated analog-digital converter (21a, 21b), by means of which an analog electrical input signal is converted into a digital electrical output signal, **characterized in that**
one of the digital output signals of the analog-digital converters (21a, 21b) is selected in order to form the digital data stream, wherein the output signal of the analog-digital converter (21a, 21b) that is selected is within a predeterminable range of the amplitude and, as a criterion of lower priority, has a positive slope and/or is greater than a predeterminable adjacent output signal.

11. Method according to claim 10, wherein the laser is operated in continuous-wave mode.

12. Method according to any of claims 10 or 11, wherein input signals of different phase are coupled with different intensity into the 2^{Q} output waveguides of the hybrid coupler (112).

## Revendications

1. Convertisseur analogique-numérique (5) comportant au moins une entrée à laquelle peut être amené au moins un signal d'entrée analogique (S(t)) et au moins une sortie (31), qui est conçu pour délivrer un flux de données numérique représentant le signal d'entrée analogique,
dans lequel
le convertisseur analogique-numérique comprend un étage d'entrée optique (1) qui est conçu pour transformer le signal d'entrée analogique (S(t)) en un signal optique modulé en phase et pour fournir ce signal à un coupleur hybride (12) ayant une pluralité de guides d'ondes de sortie (22) qui sont chacun connectés à au moins une photodiode (13a, 13b),
les contacts de connexion électrique des photodiodes (13a, 13b) sont chacun connectés à l'entrée d'un transformateur analogique-numérique associé (21a, 21b) au moyen duquel un signal d'entrée électrique analogique peut être transformé en un signal de sortie électrique numérique, et
les sorties des transformateurs analogiques-numériques (21a, 21b) sont connectées aux entrées d'un étage de sortie (3) qui est conçu pour former le flux de données numériques à la sortie (31) à partir des signaux de sortie numériques des transformateurs analogiques-numériques (21a, 21b), **caractérisé en ce que**
l'étage de sortie (3) est conçu pour sélectionner le signal de sortie du transformateur analogique-numérique (21a, 21b) qui se situe dans une plage prédéfinie de l'amplitude et qui, comme critère secondaire, présente une pente prédéfinie et/ou est supérieur à un signal de sortie voisin prédéfini.

2. Convertisseur analogique-numérique selon la revendication 1,
dans lequel
l'étage d'entrée optique (1) comprend au moins un modulateur du type Mach-Zehnder (11) et au moins un laser (10).

3. Convertisseur analogique-numérique selon la revendication 2,
dans lequel
le laser (10) peut fonctionner en mode pulsé.

4. Convertisseur analogique-numérique selon la revendication 2,
dans lequel
le laser (10) peut fonctionner en mode continu.

5. Convertisseur analogique-numérique selon l'une des revendications 1 à 4,
dans lequel
le coupleur hybride (12) comprend 2^{Q} guides d'ondes de sortie et/ou en ce que
le coupleur hybride comprend un coupleur d'interférence multimode 2 x 2 ou 4 x 4 ou 8 x 8.

6. Convertisseur analogique-numérique selon l'une des revendications 1 à 5,
dans lequel
le coupleur hybride (12) est conçu pour injecter des signaux d'entrée de différentes phases ayant différentes intensités dans les guides d'ondes de sortie.

7. Convertisseur analogique-numérique selon l'une des revendications 1 à 6,
dans lequel
l'étage de sortie (3) est conçu pour sélectionner le signal de sortie d'un transformateur analogique-numérique (21a, 21b) en fonction de la différence de phase des signaux à l'entrée du coupleur hybride (12), et pour le fournir à la sortie (31) à titre de signal de sortie du convertisseur analogique-numérique (5).

8. Convertisseur analogique-numérique selon l'une des revendications 1 à 7,
dans lequel
l'étage de sortie (3) comprend un processeur de signal numérique (30) et/ou un tableau de conversion.

9. Convertisseur analogique-numérique selon l'une des revendications 1 à 8,
dans lequel
le coupleur hybride (12) comprend 2^{Q} guides d'ondes de sortie, et les transformateurs analogiques-numériques (21a, 21b) présentent une résolution respective de P bits, et le signal d'entrée analogique peut être mis à disposition à la sortie (31) du convertisseur analogique-numérique (5) avec une résolution de (P + Q) bits.

10. Procédé pour générer un flux de données numériques qui représente un signal d'entrée analogique,
dans lequel
le signal d'entrée analogique (S(t)) est transformé en un signal optique modulé en phase et celui-ci est fourni à un coupleur hybride (12) ayant une pluralité de guides d'ondes de sortie (122) qui sont chacun connectés à au moins une photodiode (13a, 13b),
les signaux de sortie électriques des photodiodes (13a, 13b) sont chacun amenés à l'entrée d'un transformateur analogique-numérique associé (21a, 21b) au moyen duquel un signal d'entrée électrique analogique est transformé en un signal de sortie électrique numérique,
**caractérisé en ce que**
un signal parmi les signaux de sortie numériques des transformateurs analogiques-numériques (21a, 21b) est sélectionné pour former le flux de données numérique, en sélectionnant le signal de sortie du transformateur analogique-numérique (21a, 21b) qui se situe dans une plage prédéfinie de l'amplitude et qui, comme critère secondaire, présente une pente positive et/ou est supérieur à un signal de sortie voisin prédéfini.

11. Procédé selon la revendication 10,
dans lequel
le laser fonctionne en mode continu.

12. Procédé selon l'une des revendications 10 ou 11,
dans lequel
des signaux d'entrée de différentes phases ayant différentes intensités sont injectés dans les 2^{Q} guides d'ondes de sortie du coupleur hybride (12).
